Europäisches Patentamt

European Patent Office

Office européen des brevets

(11) Publication number: **0 117 867**
**A1**

## (12) EUROPEAN PATENT APPLICATION
published in accordance with Art. 158(3) EPC

(21) Application number: 82902544.4

(22) Date of filing: 26.08.82

Data of the international application taken as a basis:

(86) International application number:
PCT/JP82/00339

(87) International publication number:
WO84/01053 (15.03.84 84/07)

(51) Int. Cl.³: **H 01 L 29/72**
**H 01 L 27/08**

(43) Date of publication of application:
12.09.84 Bulletin 84/37

(84) Designated Contracting States:
DE GB

(71) Applicant: MITSUBISHI DENKI KABUSHIKI KAISHA
2-3, Marunouchi 2-chome Chiyoda-ku
Tokyo 100(JP)

(72) Inventor: IWATANI, Shiro c/o Mitsubishi Denki K. K.
Himeji Seisakusho, 840
Chiyodacho Himeji-shi Hyogo 670(JP)

(74) Representative: Lawson, David Glynne et al,
MARKS & CLERK 57-60 Lincoln's Inn Fields
London WC2A 3LS(GB)

(54) SEMICONDUCTOR DEVICE.

(57) In an integrated circuit which has a power transistor and a control transistor formed separated by an isolation region on a semiconductor substrate, a buried p-type layer (3) is formed directly on the semiconductor substrate(1), and a buried n-type layer (4) is formed on the layer (3). A high resistance n-type layer (13) is then formed by an epitaxial growth method over the whole surface, a p-type isolation diffused region (6) connected to the p-type layer (3) and an n-type isolation diffused layer (7) connected to the n-type layer (4) are formed, a control transistor or a resistor is formed in the isolated n-type epitaxial layer, and a power transistor is formed in the epitaxial layer which is not isolated.

FIG. 2

EP 0 117 867 A1

0117867

## SEMICONDUCTOR DEVICE

This invention relates to a semiconductor device structure having a plurality of semiconductor elements, particularly of high power semiconductor elements and a control semiconductor element on one semiconductor substrate.

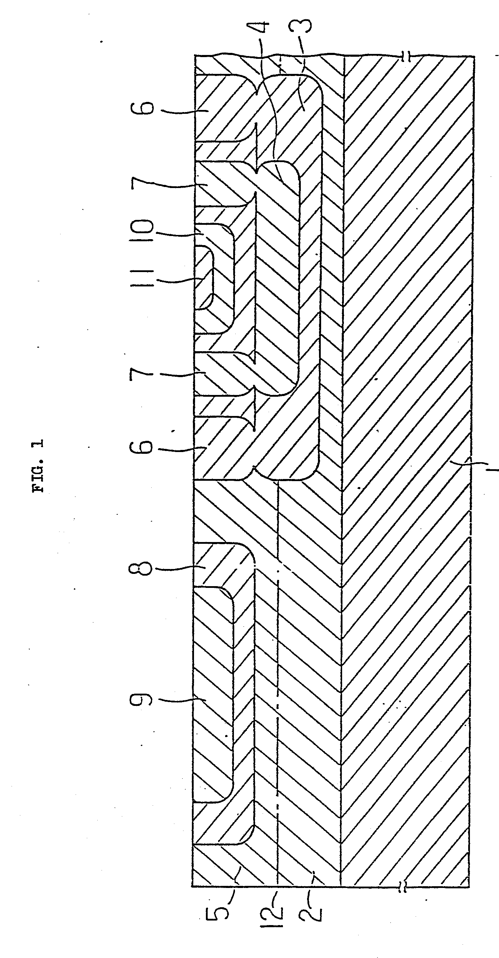

Fig. 1 is a sectional view of a conventional semiconductor device of the type referred to, in which one high power transistor and one control transistor have been formed on one semiconductor substrate.

In Figure 1, reference numeral 1 indicates an N type low resistance semiconductor substrate, 2 a first N type high resistance layer, 3 a P type buried layer, 4 an N type buried layer, 5 a second N type high resistance layer, 6 a P type wall-like layer, 7 an N type wall-like layer, 8 a P type base layer of a high power transistor, (9) an N type emitter layer of the transistor, (10) a P type base layer of a control transistor, (11) an N type emitter layer of the control transistor, and (12) is a boundary between the first N type high resistance layer (2) and the second N type high resistance layer (5).

Regarding a process of manufacturing this conventional device the description will subsequently be made. First the N type first high resistance layer (2) is formed on the N type low resistance substrate (1) according to the epitaxial growth. And the P type buried layer (3) and the N type buried layer (4) are successively formed through diffusions after which the second N type high resistance layer (2) identical in resistivity to the first N type high resistance layer (2) is epitaxially grown on the entire area of the upper surface thereof. Then the P type wall-like layer (6) is formed through the diffusion to isolate the N type high resistance layers. Then the N type wall-like layer (7) is diffused to contrive a low resistance connection to the N type buried layer (4). Thereafter there are successively formed the P type base layer (8) and the N type emiiter layer (9) of the high power transistor and the P type base layer (10) and the N type emitter layer (11) of the control transistor through diffusions. Here the N type low resistance substrate (1) forms an ohmic region for a collector of the high power transistor and the N type wall-like layer (7) forms an ohmic region for a collector of the control transistor.

In the case of such a structure of the conventional device the epitaxial growth is effected twice for the first N type high resistance layer (2) and the second N type high resistance layer (5). Thus crystal defects within the second N type high resistance layer (5) have been extremety increased to reduce a yield in the manufacturing of the device and raise the cost of the device. Also since the crystal defects are followd, the deterioration of the characteristics and more particularly of the voltage withstanding characteristic and the damage has not been avoided with respect to external surge voltages. Furthermore there have been the disadvantages that, as the epitaxial growth is effected twice, an incrase in lead time due to an increase in process and also a reduction in yield due to the increase in process occur at the same time and so on.

DISCLOSURE OF THE INVENTION

The present invention is a semiconductor device having a plurality of circuit elements on the same semiconductor substrate which has formed thereon a first region of a second type conductivity buried in and formed on one interior of the semiconductor substrate making a region of a first type conductivity, a second region of the second type conductivity formed in the form of a wall with respect to the first region of this second type conductivity, and active elements or passive elements formed on the region of the first type conductivity isolated into a plurality by the first and second regions of said second type conductivity, wherein the region of the first type conductivity is composed of a low resistance region forming the substrate and a high resistance region, and the first region of said second type conductivity is buried to bridge a boundary between the low and high resistance regions of the first type conductivity.

According to the present invention there is provided a device excellent in yield during the manufacturing of the device and in withstanding to surge voltages due to external causes and there can be provided an inexpensive device with a shorter lead time.

And the present invention has the great effect particularly with a device having a high power semiconductor element and a group of control circuit elements.

BRIEF DESCRIPTION OF THE DRAWINGS

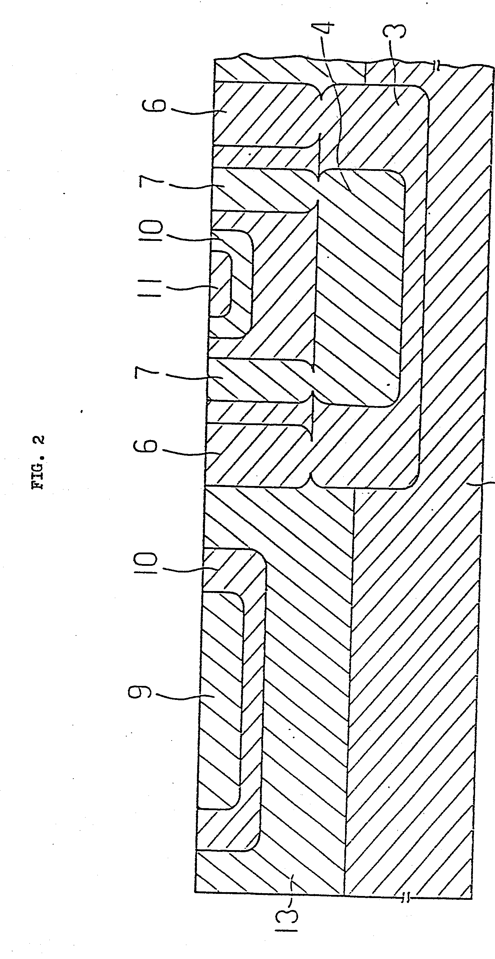

Fig. 1 is a sectional view of a conventional device, and Fig. 2 is a sectional view of one embodiment according to the present invention.

BEST MODE FOR CARRYING OUT THE INVENTION

Hereinafter one embodiment of the present invention will be described. Fig. 2 is a sectional view illustrating a structure of a semiconductor device provided in accordance with the present invention and shows the case where one high power transistor and one control transistor are formed on one semiconductor substrate.

In Figure (13) is the one and only N type high resistance layer. Still more other reference numerals are identical to those for the prior art and therefore the description therefor is omitted.

Then a process of manufacturing a semiconductor device according to the present invention is such that the P type buried layer (3) is directly formed in the N type low resistance substrate (1) through the diffusion after which the N type buried layer (4) is formed through the diffusion. Thereafter the N type high resistance layer (13) is epitaxially grown on the entire area of the upper surface thereof. On and after the formation of the P type wall-like layer (6) through the diffusion it is the same as the case of the conventional device.

Thus, in the case of the semiconductor device according to the present invention, the epitaxial growth is effected only for the N type high resistance layer 13 so that crystal defects can be minimized and a reduction in cost is contrived due to an improvement in yield during the manufacturing. Also since the crystal defects can be minimized, there is provided a device which is very resistant to external surge voltages. Furthermore since the epitaxial growth is effected only in the single step, there are the excellent effects that the process is simplified, the yield is improved due to the reduction in process as well as a reduction in lead time so on.

Adequate breakdown voltages can be provided for the P type buried layer 3 and the N type lower resistance substrate 1, by controlling the impurity concentration of the P type buried layer 3 or that of the N type low resistance substrate 1 to the optimum magnitude.

CLAIMS

(1)  A semiconductor device having a plurality of circuit elements on the same semiconductor substrate which has formed thereon a  first region of a second type conductivity  buried in and formed on one interior of the semiconductor substrate making a region of a first type conductivity, a second region of the second type conductivity formed into the form of a wall with respect to the first region of this second type conductivity, and active elements or passive elements formed in the region of the first type conductivity isolated into a plurality by the first and second regions of said second type conductivity, characterized in that the region of the first type conductivity is composed of a low resistance region making the substrate and a high resistance region, and the first region of said second type conductivity is buried to bridge a broundary between the low and high resistance regions of the first type conductivity.

(2)  A semiconductor device according to Claim 1 wherein the device has at least a high power semiconductor element and control circuit elements and is composed so that the high power semiconductor element is formed on portions of the high resistance region of the first type conductivity continuously formed with respect to the low resistance region of said first type conductivity, and the control circuit elements are formed on the high resistance region of the first type conductivity isolated by the first and second regions of the second type conductivity.

FIG. 1

0117867

FIG. 2

# INTERNATIONAL SEARCH REPORT

International Application No. PCT/JP82/00387

## I. CLASSIFICATION OF SUBJECT MATTER (If several classification symbols apply, indicate all) [3]

According to International Patent Classification (IPC) or to both National Classification and IPC

Int. Cl.$^3$  H01L 29/72, 27/08

## II. FIELDS SEARCHED

| Minimum Documentation Searched [6] | |
|---|---|
| Classification System | Classification Symbols |
| I P C | H01L 29/72, 27/08 |

| | Documentation Searched other than Minimum Documentation to the Extent that such Documents are Included in the Fields Searched [8] |
|---|---|
| | Jitsuyo Shinan Koho                1960 – 1982 <br> Kokai Jitsuyo Shinan Koho       1971 – 1982 |

## III. DOCUMENTS CONSIDERED TO BE RELEVANT [14]

| Category* | Citation of Document, [16] with indication, where appropriate, of the relevant passages [17] | Relevant to Claim No. [18] |
|---|---|---|
| Y | JP,B1, 46-2709 (Texas Instruments Inc.) 22. January. 1971  (22.01.1971) | 1, 2 |
| Y | JP,A, 50-38476 (Hitachi, Ltd.) 9. April 1975 (9.04.1975) | 1, 2 |

\* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| November 22, 1982 (22.11.82) | December 6, 1982 (06.12.82) |

| International Searching Authority [1] | Signature of Authorized Officer [20] |
|---|---|
| Japanese Patent Office | |

Form PCT/ISA/210 (second sheet) (October 1981)